# EUROPEAN PATENT APPLICATION

(11) **EP 4 641 236 A1**
(43) Date of publication of application: **29.10.2025**
(21) Application number: 24172032.5
(22) Date of filing: 23.04.2024
(51) Int. Cl.: G01R 31/396, G01R 31/54, H01M 10/48

(54) **METHOD AND SYSTEM FOR DETERMINING CONNECTIVITY FAULTS IN ENERGY STORAGE SYSTEMS**

(71) Applicant: VITO NV, 2400 Mol (BE)
(72) Inventor: Coenen, Peter, B-3380 Glabbeek (BE); Weyen, Dominique, B-2400 Mol (BE)
(74) Representative: IPLodge bv

(57) **Abstract**

The system of the invention comprises energy storage cells and detection and control circuits and is configured such that connectivity faults can be determined both in the cell connections, being the connections between the energy storage cells, and in the control connections, being the connections between each energy storage cell and the detection and control circuit. Moreover the system and method of the invention allow to discriminate between connectivity faults in control and cell connections and allow to determine the location of the connectivity fault(s) .

## Description

### FIELD OF THE INVENTION

The present invention relates to energy storage systems such as batteries and battery systems. More specifically the invention is related to determining connectivity faults in such battery systems.

### BACKGROUND OF THE INVENTION

With the ongoing transition from fossil energy to more environmental friendly alternative rechargeable energy storage systems, such as batteries and battery systems, become more and more important and are widely used to temporarily store excessive energy originating from e.g. photovoltaic solar panels and/or to at least partly drive a load when operatively connected to the battery system. All kind of appliances can be used as a load including e.g. electronic devices, and the electrical motors and other electrical systems of bikes, cars and other transportation devices.

Battery systems typically comprise multiple battery cells and a battery management system. The battery cells are mutually electrically interconnected and electrically connected to the battery management system. The battery cells are usually mutually interconnected in a series string so that the battery system is capable of generating a sufficiently high DC output voltage enabling to drive the load when operatively connected to the battery system.

The battery management system is an electronic system using programmed electronic circuits to manage the battery system. The battery management system monitors the status of the battery cells. Monitoring the status of the battery cells may include monitoring and or controlling battery cell parameters such as voltage, temperature, and state of charge, to ensure optimal performance and protect the battery system from operating outside its safe operating area. The battery management system also manages the charging and discharging of the battery. Examples of this management are stopping charging when the maximum battery voltage is reached, and balancing the respective voltages of the individual battery cells.

Both the connections between the battery cells as well as the connections between each battery cell and the battery management system are prone to failure such as e.g. an open connection. Determining open connections, which refers to identifying any disconnected or faulty connections, such as e.g. a bad contact, is crucial for ensuring the safety, performance, and reliability of the battery system.

EP 22916701 B1 discloses a battery system with interconnected battery cells. Each of the cells is connected to a measurement circuit to measure the cell voltage. To assure the accuracy / reliability of the voltage measurement for a particular cell it is determined during test whether there are any failures that could negatively influence the accuracy/ reliability of the voltage measurement.

To determine whether there is such a potential failure all battery cells are sequentially subjected to a measurement sequence executed separately for each battery cell. The measurement sequence includes a first measurement wherein the cell voltage is measured with activation of a discharge circuit and a second measurement wherein the cell voltage is measured without activation of a discharge circuit. The difference between the measured voltages in the two measurements being indicative for the presence of a failure.

The approach disclosed in EP 22916701 B1 certainly has it merits as it indicates the accuracy / reliability of a cell voltage measurement. A disadvantage however is that in case of failure the origin of the failure is unknown. Moreover the test is rather time consuming as each battery cell needs to be measured twice and the measurements of each of the battery cells are performed sequentially.

### SUMMARY OF THE INVENTION

An objective of the present invention is to provide a solution for determining a connectivity fault in a battery system enabling to discriminate between a fault in the connections between the battery cells and a fault in the connections between each of the battery cells and a detection and control circuit.

A further objective of the present invention is to provide a solution for effectively and efficiently determining a connectivity fault in a battery system in a short time frame allowing to execute the determination in the start-up sequence of the battery system and the load connected to the battery system without significantly delaying the start-up.

To at least partially overcome one or more of the mentioned or other disadvantages and/or to at least partially meet one or more of the mentioned or other objectives, the present invention concerns a method for determining a connectivity fault in an energy storage system.

The energy storage system comprises at least one energy storage battery module, each battery module comprising at least one energy storage cell, a discharge circuit for each of the at least one energy storage cell, each discharge circuit being connected to a corresponding energy storage cell and configured to at least partially discharge the corresponding energy storage cell when the discharge circuit is activated, the energy storage cells of the battery modules being interconnected in a series string via cell connections, and a detection and control circuit for each of the at least one battery module, each detection and control circuit being connected to each energy storage cell of a corresponding battery module via control connections and adapted to detect a cell voltage of each of the energy storage cells of the corresponding battery module.

The energy storage cells of the battery module or modules are mutually electrically connected via the cell connections and can be any rechargeable cells such as e.g. Li-ion battery cells. The invention is not limited to battery systems, it may also be applied to energy storage systems built up of other voltage generating devices such as fuel cells or double layer capacitors

The detection and control circuit or circuits can be part of a battery management system or can be provided separately. In the latter case they may be configured to cooperate with the battery management system if provided.

The method according to the invention comprises the step of:
a) assessing connectivity of the cell connections by detecting the cell voltages of all energy storage cells with all discharge circuits activated, and determining if any detected cell voltage has a substantial zero value. A substantial zero voltage value is an absolute value smaller than or equal to 0,25 V, preferably smaller than or equal to 0,1 V.

Detecting a cell voltage may be executed by direct measuring the cell voltage or alternatively each energy storage cell may be connected to a comparator in order to determine the cell voltage.

In an embodiment according to the invention, the substep of detecting the cell voltages in step a) of the method is followed by a substep of deactivating all discharge circuits.

In another embodiment according to the invention, if any detected cell voltage in step a) of the method is determined to have a substantial zero value, for every energy storage cell having the substantially zero voltage value the method comprises the step of identifying a connectivity fault in the cell connections of the corresponding energy storage cell.

Whereas a connection fault in the control connections may have limited safety hazards due to redundancy or functional safety often implemented in the battery management system, a connection fault in the cell connections can present a serious safety hazard, e.g. in case of Li energy storage cells a fire hazard. The method according to the invention, which may be executed in practice during the start-up sequence of the battery system prior to connecting to the load or in other words prior to activating the battery contactor enables to check first whether there are any connectivity faults in the cell connections and if so detected a repair action may be initiated first hence increasing the reliability of the system. A further advantage is that the assessment of the connectivity of the cell connections of an energy storage cell is based on a single detection of the cell voltage hence minimizing the time to execute the assessment. One may opt to detect cell voltages of all energy storage cells at the same time which will further limit the time required to execute the assessment.

The method according to the invention also comprises the step of b) assessing connectivity of the control connections by
- detecting the cell voltages of a first alternatingly selected half of all energy storage cells with the discharge circuits of the first half of the energy storage cells activated and the discharge circuits of the other second half of the energy storage cells deactivated,
- detecting the cell voltages of the second half of the energy storage cells with the discharge circuits of the second half of the energy storage cells activated and the discharge circuits of the first half of the energy storage cells deactivated, and
- determining if any detected cell voltage has a substantial zero value.

The first half of all energy storage cell may for instance be obtained by sequentially numbering all the energy storage cells of the series string e.g. from the first to the last energy storage cell in the string, and selecting either all the odd numbered energy storage cells or all the even numbered cells.

In a further embodiment according to the invention, if any detected cell voltage in step b) of the method is determined to have a substantial zero value, for every energy storage cell having the substantially zero voltage value the method comprises the step of identifying a connectivity fault in the control connections of the corresponding energy storage cell.

An advantage of the method of the present invention is that when assessing connectivity it allows to discriminate between connectivity faults in the cell connections and in the control connections. Moreover this can be done effectively and very efficient in a relatively short time period based on only three detection actions. A first action being detecting the cell voltages of all energy storage cells with all discharge circuits activated in order to identify potential connectivity faults in the cell connections. With all discharge circuits activated it is impossible to detect connectivity faults in the control connections of the energy storage system according to the invention. Potential connectivity faults in the control connections can be determined by executing a second action wherein the cell voltages of all odd energy storage cells are detected with the discharge circuits of the odd and even energy storage cells respectively activated and deactivated, followed by executing a third action wherein the cell voltages of all even energy storage cells are detected with the discharge circuits of the even and odd energy storage cells respectively activated and deactivated, or vice versa.

In another embodiment according to the invention, the cell voltages of the first half of the energy storage cells detected in step b) of the method are detected at the same time, and subsequently the cell voltages of the second half of the energy storage cells detected in step b) are detected at the same time. Alternatively, detecting the cell voltages of the energy storage cells of which the discharge circuits are activated may be done sequentially or partly in parallel.

In yet another embodiment according to the invention, if plural detected cell voltages in step b) of the method are determined to have a substantial zero value, the method comprises the steps of determining whether any of the energy storage cells with the substantial zero voltage value are adjacent to one another, and if so determined identifying a connectivity fault in a common control connection of the corresponding adjacent energy storage cells.

The invention also concerns a system for determining a connectivity fault, the system comprising at least one energy storage battery module, each battery module comprising at least one energy storage cell, a discharge circuit for each of the at least one energy storage cell, each discharge circuit being connected to a corresponding energy storage cell and configured to at least partially discharge the corresponding energy storage cell when the discharge circuit is activated, the energy storage cells of the battery modules being interconnected in a series string via first connections, and a detection and control circuit for each of the at least one energy storage battery module, each detection and control circuit being connected to each energy storage cell of a corresponding battery module via second connections and adapted to detect a cell voltage of each of the energy storage cells of the corresponding battery module, the system being configured to execute the steps of the method a described in the preceding embodiments or a combination thereof.

In an embodiment according to the invention, each discharge circuit of energy storage system comprises a controllable switch controlled by the detection and control circuit for activating or deactivating the discharge circuit.

### BRIEF DESCRIPTION OF THE DRAWINGS

With the intention of better showing the characteristics of the invention, hereafter, as an example without any limitative character, a preferred form of embodiment is described of an improved system, with reference to the accompanying drawings, wherein:
figure 1 schematically depicts a system for determining a connectivity fault according to the invention;
figure 2 schematically depicts a flowchart for determining a connectivity fault in an energy storage system according to an embodiment of the invention;
figure 3 A to D show examples of connectivity faults which can be determined according to embodiments of the invention.

### DETAILED DESCRIPTION OF A PREFERRED EMBODIMENT

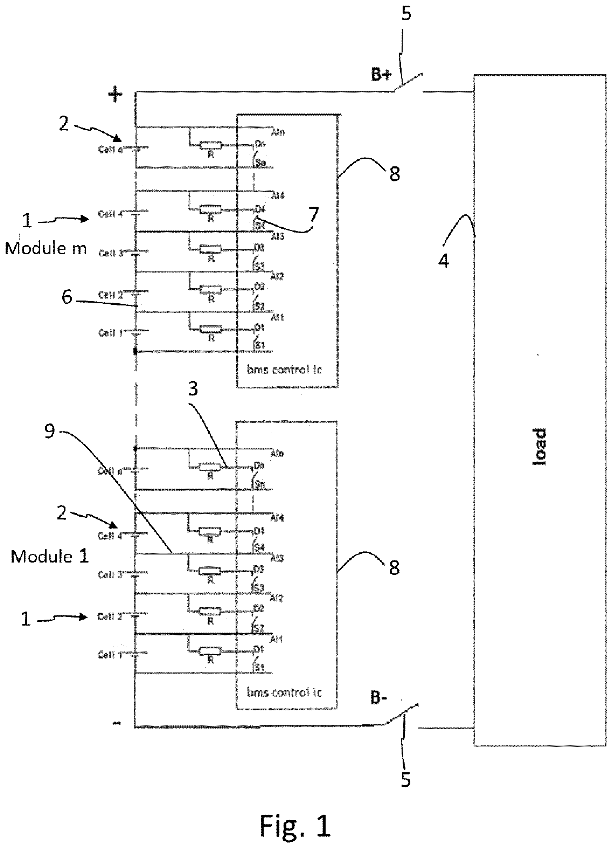

Figure 1 depicts an example of a system for determining a connectivity fault. The system comprises a rechargeable battery pack or stack connectable to a load 4. The battery pack comprises m battery modules 1, m being an integral number equal to or greater than one. Each battery module 1 comprises n energy storage cells, n being an integral number equal to or greater than one. The respective battery modules 1 can have a same or a different amount of energy storage cells 2. All energy storage cells 2 of the battery pack are electrically interconnected in series through cell connections 6. The negative terminal of the first energy storage cell of the first battery module 1 forms the negative pole of the battery pack while the positive terminal of the last energy storage cell of the last battery module (module m) 1 forms the positive pole of the battery pack. The poles of the battery pack are electrically connectable to the load 4 through battery contactors 5 that can be switched between an open and a closed position. When starting-up the contactors may be in an open position, as shown in fig.1, such that the load 4 is disconnected from the battery pack. This allows to execute tests according to the invention to determine whether there are any connectivity faults in the cell connections 6 prior to connecting the load 4 to the battery pack by closing the battery contactors 5.

For each energy storage cell 2 a discharge circuit 3 is provided which when activated is electrically connected with the terminals of the corresponding energy storage cell and is configured for partially discharging the energy storage cell. Each discharge circuit 3 comprises a balancing resistor "R", as indicated in fig.1, and a controllable switch 7, such as e.g. a transistor, which can be switched between an "ON" status wherein the switch is in a closed position and a current is allowed to flow through the discharge circuit and an "OFF" status wherein the switch is in an open position. The applicability of this technique is quite broad. It can be used by advanced BMS systems that allow active balancing where the resistors are absent but are replaced by current or voltage sources.

For each battery module 1 a battery management system control circuit comprising a detection and control circuit 8 is provided. Each energy storage cell 2 is electrically connected to the detection and control circuit 8 of the corresponding battery module 1 through control connections 9. The control connections 9 include connections between the positive terminals of each energy storage cell numbered from 1 to n to an analog input "AI", numbered correspondingly as indicated in fig. 1, of the detection and control circuit 8 of the battery module 1. The control connections 9 also include connections between the negative terminals of each energy storage cell and inputs "S", as also indicated in fig. 1, of the detection and control circuit 8 of the battery module 1. Except for the first energy storage cell of each battery module the control connection connecting the negative terminal of each energy storage cell is common with the control connection connecting the positive terminal of the adjacent energy storage cell preceding in the series string, or in other words input "Si" is the same as input "AIi-1" for i ranging from 2 to n.

Each detection and control circuit 8 is configured to control the position of the switches 7 connected thereto. Each detection and control circuit 8 is also configured to detect the cell voltages of the energy storage cells 2 connected thereto. Detecting the cell voltage of an energy storage cell can be done by measuring the voltage between the energy storage cell terminals using the analog inputs "AI" or alternatively by comparing the cell voltage with a reference voltage applied to a comparator. Detecting the cell voltage of a energy storage cell can be done with the switch 7 of the discharge circuit connected thereto in open or in closed position.

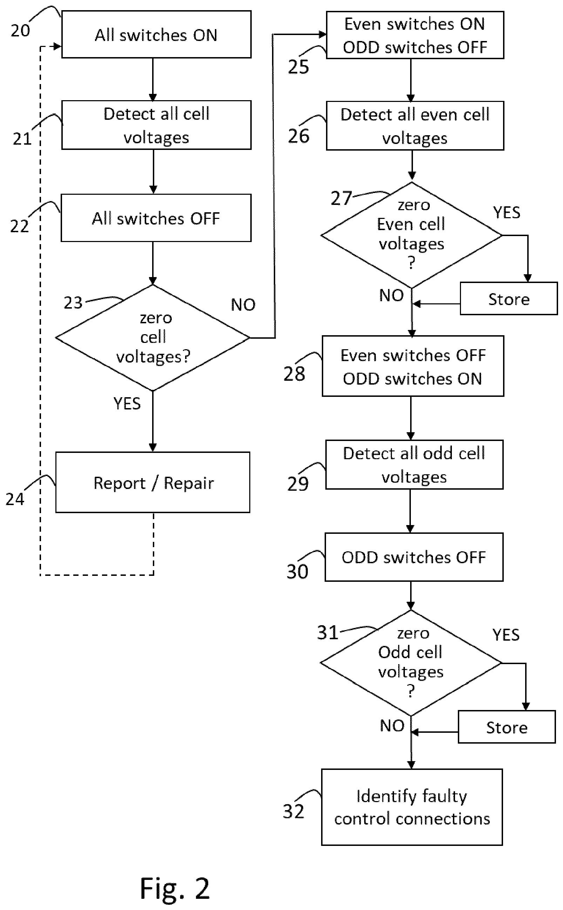

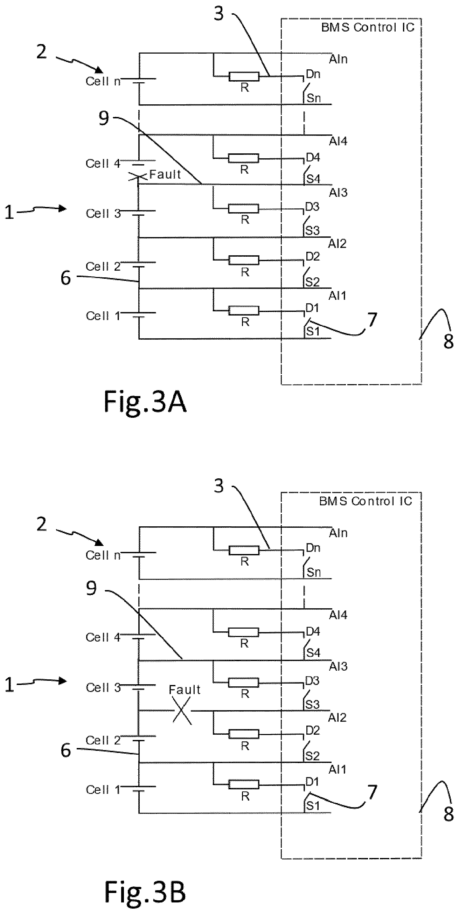

The operation of the system for determining a connectivity fault as shown in figure 1 is explained using a flowchart according to an embodiment of the invention as illustrated in fig. 2 with reference to the system shown in fig. 1 and the examples of potential connectivity faults in figures 3A to D. The steps of the flowchart are explained in more detail here below.

The assessment of the cell connections 6 is typically performed without any load 4 being connected to the battery pack, hence with the battery contactors 5 in open position. This cell connection assessment may for instance be performed during start-up of the battery system.

In order to assess whether there are connectivity faults in the cell connections 6 the discharge circuits 3 of all energy storage cells 2 of the battery pack are activated by closing 20 all switches 7 using the detection and control circuits 8. All the switches 7 are closed at the same time.

While all the discharge circuits 7 are activated, the cell voltages of all energy storage cells 2 are detected 21 with the measurement and detection circuits 8 by measuring the voltage between the terminals of each energy storage cell terminals using the analog inputs "AI". The measured cell voltages may be (temporarily) stored. All the measurements can be performed at the same time which allows a rapid an efficient testing of the cell connections 6 of all energy storage cells 2 of the battery pack. After the measurements, the discharge circuits 3 of all energy storage cells 2 of the battery pack are de-activated 22 by opening all switches 7. All the switches 7 are opened at the same time.

Subsequently it is determined 23 if any of the measured cell voltages has a substantial zero value, i.e. an absolute value smaller than or equal to 0,1 V. If no zero value cell voltages are identified, then there are no connectivity issues in the cell connections 6. This outcome may be reported. Testing can be continued immediately or may be delayed till later by initiating assessment of the control connections 9.

If however zero value cell voltages are identified, then there are connectivity issues in the cell connections 6. Assume for example, as indicated in fig. 3A, in a battery module 1 there is a connectivity fault in the cell connection 6 between the third an the fourth energy storage cell, then the measured cell voltage of the fourth energy storage cell will have a substantially zero value indicating a faulty cell connection at the negative terminal of the fourth energy storage cell and the positive terminal of the third energy storage cell. This outcome may be reported 24 and/or a warning may be issued. The battery system may not be operated anymore till a repair action has been executed. Thereafter one may consider to repeat the connectivity assessment of the cell connections 6 (and potentially perform additional repair actions) till it is confirmed that there are no connectivity issues in the cell connections 6.

It is not possible to determine a connectivity fault in the control connections 9 when assessing connectivity of the cell connections 6 using the steps as described here above. When all balancing resistors R, as indicated in fig.1, are connected, they form a voltage divider with equal voltages as well-balanced energy storage cells would have. This is also true if the balancing resistors of the discharge circuits 3 were omitted due to the impedance of the analogue inputs "AI" of the detection and measurement circuits 8.

In order to assess whether there are connectivity faults in the control connections 9 the discharge circuits 3 of a first alternatingly selected half of all energy storage cells 2 of all battery modules 1 of the battery pack are activated, for instance by closing 25 all switches 7 of all even numbered energy storage cells 2 using the detection and control circuits 8 while keeping open/ opening all switches 7 of all odd numbered energy storage cells 2. All the switches 7 of the even energy storage cells are closed at the same time.

While all the discharge circuits 7 of the even and odd energy storage cells are respectively activated and deactivated, the cell voltages of all even energy storage cells 2 are detected 26 with the measurement and detection circuits 8 by measuring the voltage between the terminals of the even energy storage cell terminals using the analogue inputs "AI". All voltage measurements of the even energy storage cells can be performed at the same time which contributes to a rapid an efficient testing. It is then determined 27 if any of the measured cell voltages of the even energy storage cells 2 has a substantial zero value, i.e. an absolute value smaller than or equal to 0,1 V. If there are any even energy storage cells identified with zero value cell voltages then the identification data of these energy storage cells are (temporarily) stored.

Subsequently, the discharge circuits 3 of all even energy storage cells 2 are deactivated by opening 28 all switches 7 of all even numbered energy storage cells 2, and the discharge circuits 3 of all odd energy storage cells 2 are activated by closing 28 all switches 7 of all odd numbered energy storage cells 2. All the switches 7 of the odd energy storage cells are closed at the same time.

While all the discharge circuits 7 of the odd and even energy storage cells are respectively activated and deactivated, the cell voltages of all odd energy storage cells 2 are detected 29 with the measurement and detection circuits 8 by measuring the voltage between the terminals of the odd energy storage cell terminals using the analog inputs "AI". All voltage measurements of the odd energy storage cells can be performed at the same time which contributes to a rapid an efficient testing. After the measurements the switches 7 of the odd energy storage cells are opened 30. It is then determined 31 if any of the measured cell voltages of the odd energy storage cells 2 has a substantial zero value, i.e. an absolute value smaller than or equal to 0,1 V. If there are any odd energy storage cells identified with zero value cell voltages then the identification data of these odd energy storage cells are (temporarily) stored.

If no zero value cell voltages of the even nor the odd energy storage cells were identified, then there are no connectivity faults determined 32 in the control connections 9. This outcome may be reported. The battery contactors may be closed.

If however zero value cell voltages are identified, then there are connectivity issues in the control connections 9 of every odd or even energy storage cell of which the identification data are stored an the location of the connectivity issue can be determined as explained in the examples here below.

Assume for example, as indicated in fig. 3B, that in a battery module 1 there is a connectivity fault in the control connection 9 between the negative terminal of the third energy storage cell and the measurement and control circuit 8 (which control connection is common with the connection between the positive terminal of the second energy storage cell and the measurement and control circuit 8). Then the measured cell voltages of both the third (odd) and the second (even) energy storage cell will have a substantially zero value. As these energy storage cells are adjacent it is clear that the faulty control connection is the common connection of both energy storage cells.

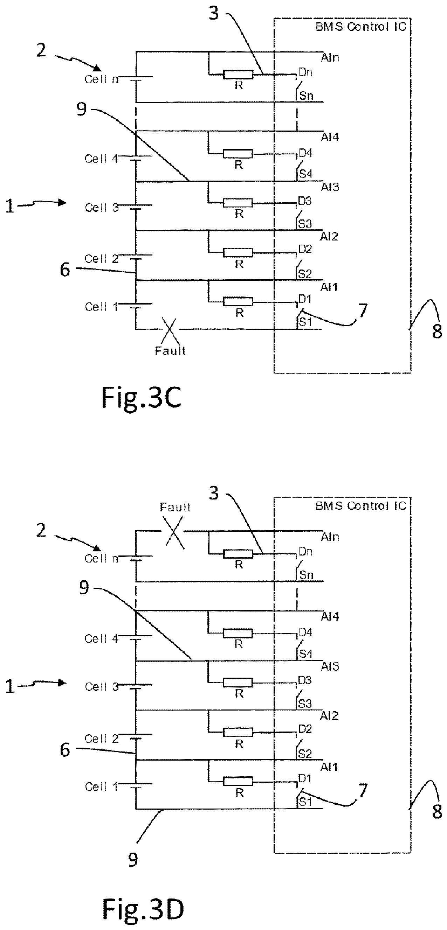

In another example, as indicated in fig. 3C, in a battery module 1 there is a connectivity fault in the control connection 9 between the negative terminal of the first energy storage cell and the measurement and control circuit 8. Then the measured cell voltage of the first energy storage cell will have a substantially zero value, while the measured cell voltage of the adjacent second energy storage cell will not have a substantially zero value.

In a further example, as indicated in fig. 3D, in a battery module 1 there is a connectivity fault in the control connection 9 between the positive terminal of the last energy storage cell and the measurement and control circuit 8. Then the measured cell voltage of the last energy storage cell will have a substantially zero value, while the measured cell voltage of the adjacent energy storage cell will not have a substantially zero value.

The present invention is in no way limited to the form of embodiment described by way of an example and represented in the figures, however, such an improved invention for determining a connectivity fault in an energy storage system can be realized in various forms without leaving the scope of the invention.

## Claims

1. A method for determining a connectivity fault in an energy storage system, the system comprising
at least one energy storage battery module (1), each battery module comprising at least one energy storage cell (2), a discharge circuit (3) for each of the at least one energy storage cell, each discharge circuit being connected to a corresponding energy storage cell and configured to at least partially discharge the corresponding energy storage cell when the discharge circuit is activated, the energy storage cells of the battery modules being interconnected in a series string via first connections (6), and
a detection and control circuit (8) for each of the at least one battery module, each detection and control circuit being connected to each energy storage cell of a corresponding battery module via second connections (9) and adapted to detect a cell voltage of each of the energy storage cells of the corresponding battery module, the method comprising the steps of:
a) assessing connectivity of the first connections by detecting the cell voltages of all energy storage cells with all discharge circuits activated, and determining if any detected cell voltage has a substantial zero value, and
b) assessing connectivity of the second connections by detecting the cell voltages of a first alternatingly selected half of all energy storage cells being one of all even and all odd energy storage cells with the discharge circuits of the first half of the energy storages cells activated and the discharge circuits of the second half of the energy storage cells being the other one of all even and all odd cells deactivated, detecting the cell voltages of the second half of the energy storage cells with the discharge circuits of the second half of the energy storage cells activated and the discharge circuits of the first half of the energy storage cells deactivated, and
determining if any detected cell voltage has a substantial zero value.

2. The method according to claim 1, **characterized in that** the cell voltages of all energy storage cells (2) detected in step a) are detected at the same time.

3. The method according to any of the preceding claims, **characterized in that** the substep of detecting the cell voltages in step a) is followed by a substep of deactivating all discharge circuits (3).

4. The method according to any of the preceding claims, **characterized in that** if any detected cell voltage in step a) is determined to have a substantial zero value, for every energy storage cell (2) having the substantially zero voltage value the method comprising the step of identifying a connectivity fault in the first connections (6) of the corresponding energy storage cell.

5. The method according to any of the preceding claims, **characterized in that** the cell voltages of the first half of the energy storage cells (2) detected in step b) are detected at the same time, and subsequently the cell voltages of the second half of the energy storage cells detected in step b) are detected at the same time.

6. The method according to any of the preceding claims, **characterized in that** if any detected cell voltage in step b) is determined to have a substantial zero value, for every energy storage cell (2) having the substantially zero voltage value the method comprising the step of identifying a connectivity fault in the second connections (9) of the corresponding energy storage cell.

7. The method according to any of the preceding claims, **characterized in that** if plural detected cell voltages in step b) are determined to have a substantial zero value, the method comprising the steps of determining whether any of the energy storage cells (2) with the substantial zero voltage value are adjacent to one another, and if so determined identifying a connectivity fault in a common second connection (9) of the corresponding adjacent energy storage cells.

8. A system for determining a connectivity fault, the system comprising
at least one energy storage battery module (1), each battery module comprising at least one energy storage cell (2), a discharge circuit (3) for each of the at least one energy storage cell, each discharge circuit being connected to a corresponding energy storage cell and configured to at least partially discharge the corresponding energy storage cell when the discharge circuit is activated, the energy storage cells of the battery modules being interconnected in a series string via first connections (6), and
a detection and control circuit (8) for each of the at least one energy storage battery module, each detection and control circuit being connected to each energy storage cell of a corresponding battery module via second connections (9) and adapted to detect a cell voltage of each of the energy storage cells of the corresponding battery module, the system being configured to execute the steps of the method according to any of the preceding claims.

9. The system according to claim 8, **characterized in that** each discharge circuit (3) comprises a controllable switch (7) controlled by the detection and control circuit (8) for activating or deactivating the discharge circuit.

10. The system according to claim 8 or 9, **characterized in that** the detection and control circuit (8) is part of a battery management system and/or the detection and control circuit (8) is configured to cooperate with the battery management system.
